# EUROPEAN PATENT APPLICATION

(11) **EP 4 694 613 A1**
(43) Date of publication of application: **11.02.2026**
(21) Application number: 24915861.9
(22) Date of filing: 10.09.2024
(51) Int. Cl.: H10B 41/30, H10D 30/68, H10D 64/27, H10D 30/67, G11C 16/10, G11C 16/30

(54) **RECONFIGURABLE ELECTRONIC DEVICE USING AMBIPOLAR TWO-DIMENSIONAL SEMICONDUCTOR, METHOD FOR MANUFACTURING SAME, AND LOGIC DEVICE USING SAME**

(30) Priority: 25.06.2024 KR 20240082956
(71) Applicant: Seoul National University R&DB Foundation, Gwanak-gu Seoul 08826 (KR)
(72) Inventor: LEE, Gwan-Hyoung, Seoul 08826 (KR); HWANG, Cheol Seong, Seoul 08826 (KR); SHIN, June-Chul, Seoul 08826 (KR); SHIN, Dong Hoon, Seoul 08826 (KR); CHOI, Hyun-Young, Seoul 08826 (KR); PARK, Taegyun, Seoul 08826 (KR)
(74) Representative: Lippert Stachow Patentanwälte Rechtsanwälte Partnerschaft mbB
(86) International application number: PCT/KR2024/013710
(87) International publication number: WO 2026/005124

(57) **Abstract**

A reconfigurable electronic device that may perform various operations by adjusting the type and concentration of a charge stored in a floating gate, and a manufacturing method thereof and a logic device using thereof, are provided. Such reconfigurable electronic device comprises a control gate; a floating gate that is formed on the control gate and that is electrically insulated from surroundings; a tunnelling layer that is formed on the floating gate; a channel layer that is formed on the tunnelling layer and that is composed of the ambipolar two-dimensional semiconductor; and a first electrode and a second electrode, that are formed on the channel layer to be spaced apart from each other. Here, the channel layer has any one characteristics of a conductor, an n-type semiconductor, an insulator and a p-type semiconductor depending on the polarity and magnitude of a program voltage applied to the control gate.

## Description

### 1. Field

The present disclosure relates to a reconfigurable electronic device, manufacturing method thereof, and logic device using the same, and more specifically, to a reconfigurable electronic device having transistor and memory functions using an ambipolar two-dimensional semiconductor, a manufacturing method thereof, and a logic device using the same.

### 2. Background

The current commercially available silicon semiconductor transistors are undergoing major technological development in the direction of reducing device size to increase device integration density. However, due to limitations in miniaturization process technology and short-channel effects etc., there is a physical limit to reducing the size of the devices.

To solve these problems, two-dimensional materials with high charge mobility and the ability to suppress short-channel effects are being developed as semiconductor materials to replace silicon. Additionally, research on three-dimensional integrated circuits that provide high integration density and performance by stacking electronic devices vertically, is actively progressing. However, unlike memories, transistor-based three-dimensional integration technology has limitations in the number of vertical layers that may be stacked due to the high heat generated during computation operations.

Accordingly, with a growing need for a new method that can improve device integration density, reconfigurable transistors, which may perform various operations by reconfiguring electrical characteristics in a single device, have recently gained attention. When using reconfigurable transistors, various computations may be performed in a single circuit, improving area efficiency, and thus significant research is being conducted in this area. However, a conventional reconfigurable transistor device has a problem in that it is composed of two or more gate terminals, which complicates circuit configuration and reduces the practical efficiency of integration density.

### SUMMARY

The problem to be solved by the present disclosure is to provide a reconfigurable electronic device that may perform various operations in a single device by adjusting the type and concentration of charges stored in a floating gate.

Another problem to be solved by the present disclosure is to provide a method for manufacturing such a reconfigurable electronic device.

Yet another problem to be solved by the present disclosure is to provide a logic device using such a reconfigurable electronic device.

The problems to be solved by the present disclosure are not limited to those mentioned above, and other problems not specifically mentioned will be clearly understood by those skilled in the art that the present disclosure belongs to from the descriptions provided below.

A reconfigurable electronic device according to one embodiment of the present disclosure for solving the problems mentioned above is a reconfigurable electronic device with transistor and memory functions using an ambipolar two-dimensional semiconductor, including a control gate; a floating gate that is formed on the control gate and that is electrically insulated from surroundings; a tunneling layer that is formed on the floating gate; a channel layer that is formed on the tunneling layer and that is composed of the ambipolar two-dimensional semiconductor; and a first electrode and a second electrode, that are formed on the channel layer to be spaced apart from each other. Here, the channel layer has any one of the characteristics of a conductor, an n-type semiconductor, an insulator, and a p-type semiconductor depending on the polarity and magnitude of a program voltage applied to the control gate.

The channel layer may be composed of least one ambipolar two-dimensional semiconductor selected from a group consisting of WSe₂, MoTe₂, and BP.

The floating gate may be composed of at least one two-dimensional conductor selected from a group consisting of graphene and PtTe₂.

The tunneling layer may be composed of at least one two-dimensional insulator selected from a group consisting of hBN and Sb₂O₃.

The floating gate, the tunneling layer, and the channel layer may all be composed of two-dimensional materials, and may be sequentially stacked on the control gate using a dry transfer method using a PDMS stamp.

As an absolute value of the program voltage increases with positive polarity, the channel layer may sequentially have characteristics of the insulator, p-type semiconductor, and conductor.

As an absolute value of the program voltage increases with negative polarity, the channel layer may sequentially have characteristics of the insulator, n-type semiconductor, and conductor.

When a first voltage < a second voltage < a third voltage < 0 < a fourth voltage < a fifth voltage < a sixth voltage, if the program voltage is less than or equal to the first voltage or greater than or equal to the sixth voltage, the channel layer may have conductor characteristics, if the program voltage is ranging from the first voltage to the second voltage, the channel layer may have n-type semiconductor characteristics, if the program voltage is ranging from the second voltage to the third voltage or from the fourth voltage to the fifth voltage, the channel layer may have insulator characteristics, and if the program voltage is ranging from the fifth voltage to the sixth voltage, the channel layer may have p-type semiconductor characteristics.

If the program voltage is less than or equal to -60V or greater than or equal to 60V, the channel layer may have conductor characteristics, and if the program voltage is ranging from -60V to -45V, the channel layer may have n-type semiconductor characteristics, if the program voltage is ranging from -45V to -30V or 30V to 45V, the channel layer may have insulator characteristics, and if the program voltage is ranging from 45V to 60V, the channel layer may have p-type semiconductor characteristics.

A method of manufacturing a reconfigurable electronic device according to one embodiment of the present disclosure for solving another problem mentioned above is a method of manufacturing a reconfigurable electronic device with transistor and memory functions using an ambipolar two-dimensional semiconductor, including preparing a control gate; sequentially stacking a floating gate, a tunneling layer, and a channel layer on the control gate using a dry transfer method using a PDMS stamp, the channel layer being composed of the ambipolar two-dimensional semiconductor; forming a resist pattern on the channel layer; and forming a first electrode and a second electrode, that are spaced apart from each other, on the channel layer that is exposed by the resist pattern. Here, the channel layer has any one of the characteristics of a conductor, an n-type semiconductor, an insulator, and a p-type semiconductor depending on the polarity and magnitude of a program voltage applied to the control gate.

A logic device according to one embodiment of the present disclosure for solving another problem mentioned above is a logic device including a first electronic device and a second electronic device, having a same structure as the electronic device mentioned above; and a first power source and a second power source, wherein the first electronic device and the second electronic device are connected in series between the first power source and the second power source, a first electrode of the first electronic device is connected to the first power source, a second electrode of the first electronic device is connected to the first electrode of the second electronic device, and from a connection point thereof, an output signal is output, a second electrode of the second electronic device is connected to the second power source, and a same input signal (A) is input into a control gate of the first electronic device and into a control gate of the second electronic device.

The logic device may perform four logical operations depending on the polarity and magnitude of a program voltage applied to the control gate of each electronic device.

The four logical operations may be A, NOT A, TRUE, and FALSE for the input signal (A).

A logic device according to another embodiment of the present disclosure for solving another problem mentioned above is a logic device including a first electronic device to a fifth electronic device having a same structure as the electronic device mentioned above, a first power source and a second power source, wherein a first electrode of the fifth electronic device is connected to the first power source, a control gate of the fifth electronic device is connected to a second electrode of the fifth electronic device, the first electronic device and the second electronic device are connected in series between a second electrode of the fifth electronic device and the second power source, the third electronic device and the fourth electronic device are connected in series between the second electrode of the fifth electronic device and the second power source, a first electrode of the first electronic device and a first electrode of the third electronic device are connected to the second electrode of the fifth electronic device, and from a connection point thereof, and an output signal is output, a second electrode of the first electronic device, a first electrode of the second electronic device, a second electrode of the third electronic device, and a first electrode of the fourth electronic device are interconnected, a second electrode of the second electronic device and a second electrode of the fourth electronic device are connected to the second power source, a same first input signal (A) is input into a control gate of the first electronic device and into a control gate of the second electronic device, and a same second input signal (B) is input into a control gate of the third electronic device and into a control gate of the fourth electronic device.

The logic device may perform sixteen logical operations depending on the polarity and magnitude of a program voltage applied to the control gate of each electronic device.

The sixteen logical operations may be A, NOT A, B, NOT B, TRUE, FALSE, AND, OR, NOR, NAND, XOR, XNOR, IMP, NIMP, RIMP, and RNIMP for the first input signal (A) and the second input signal (B).

A channel layer of the fifth electronic device may be set to have n-type semiconductor characteristics by a program voltage.

Specific details of other embodiments are included in the detailed descriptions and drawings.

As described above, according to the reconfigurable electronic device of the present disclosure, memory and transistor functions may be performed through one control gate by adding a tunneling layer and a floating gate to a conventional transistor structure. For example, when a high program voltage is applied to the control gate, charges may be stored in or removed from the floating gate, allowing the reconfigurable electronic device to function as memory. Additionally, when a low gate voltage is applied to the control gate, the charge stored in the floating gate remains in a fixed state without change, allowing the device to perform switching operations like a transistor device. Thus, the reconfigurable electronic device of the present disclosure is a device that may be used both as a processor performing computations and as a memory chip.

The reconfigurable electronic device of the present disclosure is a three-terminal device consisting of a control gate, a first electrode, and a second electrode, with no electrode connected to the floating gate, and thus the circuit configuration is simple, and integration density efficiency can be increased.

The channel layer of the reconfigurable electronic device of the present disclosure is composed of an ambipolar two-dimensional semiconductor material, allowing the type and concentration of charges stored in the floating gate to be adjusted based on the polarity and magnitude of the program voltage applied to the control gate. Accordingly, the reconfigurable electronic device may operate as any one of a conductor, an n-type semiconductor, an insulator, and a p-type semiconductor. By enabling these four types of operation with a single electronic device, integration density efficiency can be enhanced.

The floating gate, tunneling layer, and channel layer of the reconfigurable electronic device of the present disclosure are all composed of two-dimensional materials, and thus have high charge mobility and can suppress short-channel effects.

A logic device composed of two reconfigurable electronic devices according to the present disclosure may perform four logic operations based on the polarity and magnitude of the program voltage applied to the control gate of each electronic device. For example, the logic device may perform logic operations such as A, NOT A, TRUE, and FALSE for an input signal (A).

A logic device composed of five reconfigurable electronic devices according to the present disclosure may perform sixteen logic operations based on the polarity and magnitude of the program voltage applied to the control gate of each electronic device. For example, the logic device may perform logic operations such as A, NOT A, B, NOT B, TRUE, FALSE, AND, OR, NOR, NAND, XOR, XNOR, IMP, NIMP, RIMP, and RNIMP for the first input signal (A) and the second input signal (B).

### BRIEF DESCRIPTION OF THE DRAWINGS

FIG. 1 is a diagram schematically illustrating a reconfigurable electronic device according to one embodiment of the present disclosure.
FIG. 2 is a cross-sectional view of the reconfigurable electronic device of FIG. 1.
FIG. 3 is a diagram showing the ambipolar memory characteristics of the reconfigurable electronic device of FIG. 1.
FIG. 4 is a diagram illustrating the electrical characteristics of the reconfigurable electronic device of FIG. 1 as a function of the program voltage.
FIG. 5 is a circuit diagram of a logic device according to one embodiment of the present disclosure.
FIG. 6 is diagram explaining the operation of the logic device of FIG. 5.
FIG. 7 is a circuit diagram of a logic device according to another embodiment of the present disclosure.
FIG. 8 is a diagram illustrating the logic operations performed by the logic device of FIG. 7.
FIG. 9 is a diagram illustrating the input signal and the output signal based on the logic operations of FIG. 8.
FIG. 10 a circuit diagram and logic operation diagram of a logic device block according to one embodiment of the present disclosure.

### DETAILED DESCRIPTION

The advantages and features of the present disclosure, as well as the methods for achieving them, will become clear by referring to the embodiments described in detail below, along with the accompanying drawings. However, the present disclosure is not limited to the embodiments disclosed hereinbelow and may be implemented in various other forms. The present embodiments are provided only to ensure that the disclosure of the present disclosure is complete and to fully inform those skilled in the related art that the present disclosure belongs to, which is defined solely by the claims. Throughout the specification, like reference numerals refer to like components.

Throughout this specification, when a part is described as 'comprising' a component, unless specifically disclosed otherwise, it doesn't mean that other components are excluded but it means that other components may be further included.

Throughout this specification, when a member is described as being located 'on' another member, it includes not only cases where that member is in contact with the other member but also cases where there is another member present between the two.

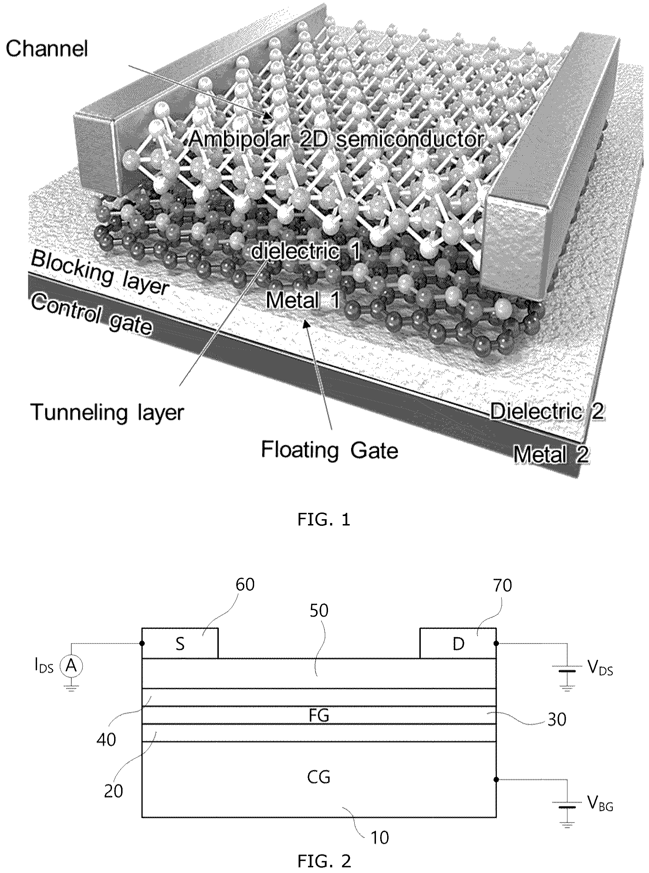

The structure of a reconfigurable electronic device according to one embodiment of the present disclosure will be described in detail below with reference to FIGs. 1 and 2. FIG. 1 is a diagram schematically illustrating a reconfigurable electronic device according to one embodiment of the present disclosure. FIG. 2 is a cross-sectional view of the reconfigurable electronic device of FIG. 1.

The reconfigurable electronic device has transistor and memory functions using an ambipolar two-dimensional semiconductor. Specifically, the reconfigurable electronic device includes a control gate 10, a blocking layer 20, a floating gate 30, a tunneling layer 40, a channel layer 50, a first electrode 60, and a second electrode 70.

The control gate 10 may be composed of a semiconductor, a two-dimensional conductor, bulk metal, or a combination thereof. For example, the control gate 10 may be composed of at least one semiconductor selected from a group consisting of Si, GaAs, SiC, GaN, and InP. Alternatively, the control gate 10 may consist of at least one two-dimensional conductor selected from a group consisting of graphene and PtTe₂. Or, the control gate 10 may be composed of at least one bulk metal selected from a group consisting of Pt and Au.

The blocking layer 20 is formed on the control gate 10, and may be composed of a two-dimensional insulator, a bulk insulator, or a combination thereof. For example, the blocking layer 20 may be composed of at least one two-dimensional insulator selected from a group consisting of hexagonal boron nitride (hBN) and Sb₂O₃. Alternatively, the blocking layer 20 may be composed of at least one bulk insulator selected from a group consisting of HfO₂, Al₂O₃, ZrO₂, and SiO₂.

The floating gate 30 is formed on the control gate 10, preferably on the blocking layer 20. The floating gate 30 is electrically insulated from its surroundings, and is not connected to a separate electrode. The floating gate 30 may be composed of a two-dimensional conductor, bulk metal, or a combination thereof. For example, the floating gate 30 may be composed of at least one two-dimensional conductor or a two-dimensional material selected from a group consisting of graphene and PtTe₂. Alternatively, the floating gate 30 may be composed of at least one bulk metal selected from a group consisting of Pt and Au. Depending on the amount and type of charge stored in the floating gate 30, the reconfigurable electronic device may perform four roles, that is, a conductor, an n-type semiconductor, an insulator, and a p-type semiconductor.

The tunneling layer 40 is formed on the floating gate 30, and may be composed of a two-dimensional insulator, a bulk insulator, or a combination thereof. For example, the tunneling layer 40 may be composed of at least one two-dimensional insulator or two-dimensional material selected from a group consisting of hexagonal boron nitride (hBN) and Sb₂O₃. Alternatively, the tunneling layer 40 may be composed of at least one bulk insulator selected from a group consisting of HfO₂, Al₂O₃, ZrO₂, and SiO₂.

The channel layer 50 is formed on the tunneling layer 40, and may be composed of a two-dimensional semiconductor material or a two-dimensional material that has high charge mobility and a suppression effect for short-channel effect. For example, the channel layer 50 may be composed of graphene, a transition metal chalcogenide, black phosphorus (BP), or a combination thereof. Here, transition metal chalcogenides may be transition metal dichalcogenides (TMD) represented by the chemical formula MX₂ (M: transition metal, X: chalcogen element). Transition metal dichalcogenides (TMD) include transition metal disulfides (MS₂), transition metal diselenides (MSe₂), or transition metal ditelurides (MTe₂). For example, transition metal dichalcogenides (TMD) may be MoS₂, WS₂, TiS₂, MoSe₂, WSe₂, MoTe₂, or WTe₂. Preferably, the channel layer 50 may be composed of ambipolar two-dimensional semiconductors. For example, the channel layer 50 may be composed of at least one ambipolar two-dimensional semiconductor selected from a group consisting of WSe₂, MoTe₂, and BP.

The first electrode 60 and the second electrode 70 are formed spaced apart from each other on the channel layer 50. The first electrode 60 is either one of a source electrode or a drain electrode, while the second electrode 70 is the other one of the source electrode or the drain electrode. In this embodiment, the first electrode 60 is described as the source electrode, and the second electrode 70 as the drain electrode, for example; however, the present disclosure is not limited thereto, and the first electrode 60 may be the drain electrode with the second electrode 70 being the source electrode. The first electrode 60 and the second electrode 70 may be composed of a semiconductor, a two-dimensional conductor, bulk metal, or a combination thereof. For example, the first electrode 60 and the second electrode 70 may be composed of at least one semiconductor selected from a group consisting of Si, GaAs, SiC, GaN, and InP. Alternatively, the first electrode 60 and the second electrode 70 may be composed of at least one two-dimensional conductor selected from a group consisting of graphene and PtTe₂. Or, the first electrode 60 and the second electrode 70 may be composed of at least one bulk metal selected from a group consisting of Pt and Au.

Hereinbelow, a manufacturing method of the reconfigurable electronic device according to one embodiment of the present disclosure will be described in detail with reference to FIG. 2.

A control gate 10 or a control gate 10 with a blocking layer 20 formed on its top is prepared.

Using a dry transfer method with a PDMS stamp, a floating gate 30, a tunneling layer 40, and a channel layer 50 are sequentially stacked on the control gate 10, preferably on the blocking layer 20. The dry transfer method uses a hemispherical PDMS stamp and a polycarbonate (PC) thin film on a slide glass.

Next, a resist pattern is formed on the channel layer 50. Specifically, a resist is stacked on the channel layer 50 using spin coating, and using lithography, the resist pattern is formed such that a part of the channel layer 50 is exposed. Here, the resist may consist of photoresist (PR), electron beam resist (e-beam resist), etc. Lithography may consist of photolithography, electron beam lithography, etc.

On the channel layer 50 exposed by the resist pattern, a first electrode 60 and a second electrode 70 that are spaced apart from each other are formed. The first electrode 60 and the second electrode 70 may be formed using physical vapor deposition (PVD) or chemical vapor deposition (CVD). Physical vapor deposition (PVD) methods include electron beam evaporation (E-beam evaporation), atomic layer deposition (ALD), thermal evaporation, and sputtering.

After the first electrode 60 and the second electrode 70 are formed, the resist pattern is removed through lift-off.

### <Manufacturing Example 1>

In order to dry transfer a two-dimensional material, a hemispherical PDMS stamp was formed on top of a slide glass, and a polycarbonate (PC) film was attached onto the PDMS stamp, and was then heated at atmospheric pressure to 150-200°C on a hot plate so that the PC film adhered evenly to the PDMS stamp. The slide glass on which the PDMS stamp was formed was coupled to a positioner of a probe station, and the movement of the PDMS stamp was controlled using the positioner.

A SiO₂ substrate on which a WSe₂ channel layer was formed was heated at atmospheric pressure to 100-150°C, and the PDMS stamp was placed on top of the SiO₂ substrate, and then the PDMS stamp was lowered to pick up the WSe₂ channel layer.

Next, the SiO₂ substrate on which an hBN tunneling layer was formed was heated at atmospheric pressure to 100-150°C, and on the WSe₂ channel layer attached below the PDMS stamp, the hBN tunneling layer was aligned, and then the PDMS stamp was lowered such that the hBN tunneling layer is attached to the WSe₂ channel layer to pick up the hBN tunneling layer.

Next, a SiO₂ blocking layer was formed on a Si substrate used as a control gate, and a graphene floating gate was formed on the SiO₂ blocking layer. This SiO₂/Si substrate on which the graphene floating gate was formed was heated at atmospheric pressure to 100-150°C, and the graphene floating gate was aligned with the WSe₂/hBN that was attached below the PDMS stamp, and then the PDMS stamp was lowered such that the graphene floating gate is attached to the WSe₂/hBN.

With the WSe₂/hBN bonded to the graphene floating gate, the SiO₂/Si substrate was heated at atmospheric pressure to 170-200°C to attach a PC film and the WSe₂/hBN/graphene to the SiO₂/Si substrate, and the PC film was removed using an organic solvent. Through this process, on the Si control gate, a structure where the SiO₂ blocking layer, graphene floating gate, hBN tunneling layer, and WSe₂ channel layer were sequentially stacked was formed.

On the stacked structure, particularly on the WSe₂ channel layer, electron beam resist was applied using spin coating. The result of this was heated at atmospheric pressure to 120-180 degrees for several minutes, and then an electron beam resist pattern was formed using electron beam lithography equipment.

On the channel layer exposed by the electron beam resist pattern, Ti and Au were sequentially deposited using electron beam evaporation to form a first electrode and a second electrode that are spaced apart from each other. Next, the electron beam resist pattern was removed, completing the reconfigurable electronic device as shown in FIG. 2.

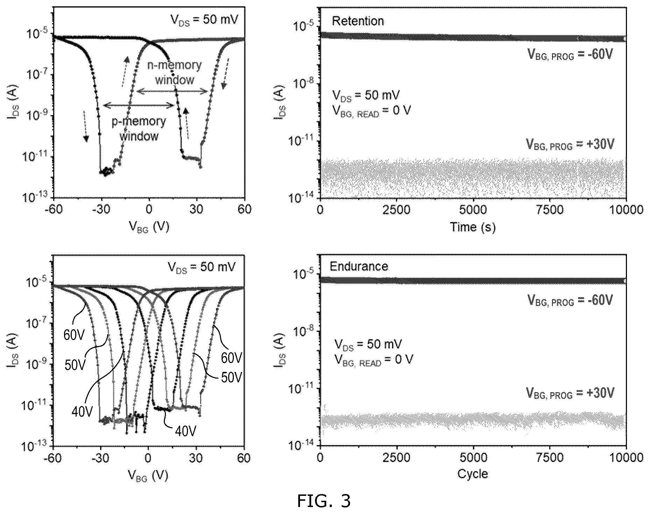

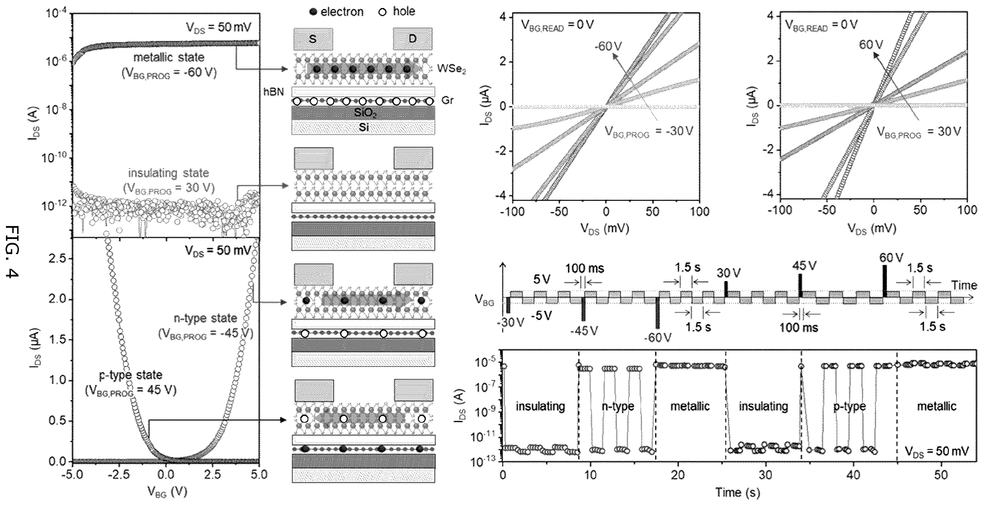

Hereinafter, with reference to FIGs. 3 and 4, the performance and operation of the reconfigurable electronic device according to one embodiment of the present disclosure will be described in detail. FIG. 3 is a diagram showing the ambipolar memory characteristics of the reconfigurable electronic device of FIG. 1. FIG. 4 is a diagram illustrating the electrical characteristics of the reconfigurable electronic device of FIG. 1 as a function of the program voltage.

As shown in FIG. 3, it was confirmed that a transfer curve V_{BG}-I_{DS} of the reconfigurable electronic device has significant ambipolar hysteresis in both n-type and p-type, which indicates the ambipolar memory characteristics due to charges stored in the floating gate. It was also confirmed that as the range of a gate voltage increases when a gate voltage sweeps, an n-memory window and a p-memory window expand, indicating that the concentration and type of the charge stored in the floating gate change according to the gate voltage. Additionally, retention measurements and endurance measurements showed that the reconfigurable electronic device of the present disclosure has high retention of 10,000 or more seconds and maintains a constant conductivity for 10,000 cycles, confirming its excellent memory characteristics.

As shown in FIG. 4, the type and concentration (or density) of the charge trapped (or stored) in the floating gate may be controlled according to the polarity and magnitude of the program voltage applied to the control gate, thereby allowing for the adjustment of the doping concentration of the channel layer.

Therefore, depending on the polarity and magnitude of the program voltage applied to the control gate, the channel layer has characteristics of any one of a conductor, an n-type semiconductor, an insulator, and a p-type semiconductor. As the absolute value of the program voltage increases in the positive polarity, the channel layer sequentially has characteristics of an insulator, a p-type semiconductor, and a conductor. As the absolute value of the program voltage increases in the negative polarity, the channel layer sequentially has characteristics of an insulator, an n-type semiconductor, and a conductor.

When a first voltage < a second voltage < a third voltage < 0 < a fourth voltage < a fifth voltage < a sixth voltage, if the program voltage is less than or equal to the first voltage or greater than or equal to the sixth voltage, the channel layer has conductor characteristics. If the program voltage is ranging from the first voltage to the second voltage, the channel layer has n-type semiconductor characteristics. If the program voltage is ranging from the second voltage to the third voltage or the fourth voltage to the fifth voltage, the channel layer has insulator characteristics. If the program voltage is ranging from the fifth voltage to the sixth voltage, the channel layer has p-type semiconductor characteristics.

For example, when the program voltage is less than or equal to -60V or greater than or equal to 60V, the channel layer may have conductor characteristics, when the program voltage is ranging from -60V to -45V, the channel layer may have n-type semiconductor characteristics, when the program voltage is ranging from -45V to -30V or 30V to 45V, the channel layer may have insulator characteristics, and when the program voltage is ranging from 45V to 60V, the channel layer may have p-type semiconductor characteristics. Such a program voltage may vary depending on the type and thickness of the blocking layer (or gate oxide) stacked below the control gate. The previously described example indicates the use of a SiO₂ dielectric with a thickness of 270 to 300 nm as the blocking layer. If the blocking layer is formed to be approximately 30 nm thick, the program voltage may be reduced to about 1/6 of its original level overall.

In this embodiment, the program voltage may be applied to the control gate in the form of pulses (e.g., 100 ms). By applying a high program voltage of 30V or more to the control gate, the type and concentration (or density) of charges stored in the floating gate may be adjusted. Depending on the type and concentration of charges stored in the floating gate, the doping type and doping concentration of the channel layer may be changed. When a relatively small gate voltage (e.g., -5V to 5V) is applied to the control gate, it has been confirmed that the channel layer has characteristics of any one of a conductor, an insulator, an n-type semiconductor, and a p-type semiconductor.

For instance, referring to the metallic state data of the transfer curve V_{BG}-I_{DS} in FIG. 4, when a program voltage of -60V or less is applied to the control gate in a pulse form (100 ms), a relatively large number of electrons in the floating gate pass through the tunneling layer and move to the channel layer, doping the channel layer with electrons. Measuring the transfer curve V_{BG}-I_{DS} for gate voltages ranging from -5V to 5V confirmed that the reconfigurable electronic device or channel layer has conductor characteristics. Accordingly, the type and concentration of charges stored in the floating gate may be adjusted by the program voltage, and since the stored charges may be maintained for a long period of time, the reconfigurable electronic device also has memory characteristics. Additionally, an output curve V_{DS}-I_{DS} has a linear relationship and shows ohmic contact characteristics.

For example, referring to the n-type state data of the transfer curve V_{BG}-I_{DS} in FIG. 4, when a program voltage ranging from -60V to - 45V is applied to the control gate in a pulse form (100 ms), a relatively small number of electrons in the floating gate pass through the tunneling layer and move to the channel layer, doping the channel layer with electrons. Measuring the transfer curve V_{BG}-I_{DS} for gate voltages ranging from -5V to 5V confirmed that the reconfigurable electronic device or channel layer has n-type semiconductor characteristics. Thus, the type and concentration of charges stored in the floating gate may be controlled by the program voltage, and since the stored charges may be maintained for a long period of time, the reconfigurable electronic device also has memory characteristics. Additionally, the output curve V_{DS}-I_{DS} has a linear relationship and shows ohmic contact characteristics.

For example, referring to the insulating state data of the transfer curve V_{BG}-I_{DS} in FIG. 4, when a program voltage ranging from - 45V to -30V or 30V to 45V is applied to the control gate in a pulse form (100 ms), there is no tunneling of charges or doping of the channel layer. Measuring the transfer curve V_{BG}-I_{DS} for gate voltages ranging from -5V to 5V confirmed that the reconfigurable electronic device or channel layer has insulator characteristics. Thus, the type and concentration of charges stored in the floating gate may be controlled by the program voltage, and since the stored charges may be maintained for a long period of time, the reconfigurable electronic device also has memory characteristics.

For example, referring to the p-type state data of the transfer curve V_{BG}-I_{DS} of FIG. 4, when a program voltage ranging from 45V to 60V is applied to the control gate in a pulse form (100 ms), a relatively small number of electrons in the channel layer pass through the tunneling layer and move to the floating gate, doping the channel layer with holes. Measuring the transfer curve V_{BG}-I_{DS} for gate voltages ranging from -5V to 5V confirmed that the reconfigurable electronic device or channel layer has p-type semiconductor characteristics. Thus, the type and concentration of charges stored in the floating gate may be adjusted by the program voltage, and since the stored charges may be maintained for a long period of time, the reconfigurable electronic device also has memory characteristics. Additionally, the output curve V_{DS}-I_{DS} has a linear relationship and shows ohmic contact characteristics.

For example, when a program voltage that is greater than or equal to 60V is applied to the control gate in a pulse form (100 ms), a relatively large number of electrons in the channel layer pass through the tunneling layer and move to the floating gate, doping the channel layer with holes. Measuring the transfer curve V_{BG}-I_{DS} for gate voltages ranging from -5V to 5V confirmed that the reconfigurable electronic device or channel layer has conductor characteristics. Thus, the type and concentration of charges stored in the floating gate may be adjusted by the program voltage, and since the stored charges may be maintained for a long period of time, the reconfigurable electronic device also has memory characteristics. Additionally, the output curve V_{DS}-I_{DS} has a linear relationship and shows ohmic contact characteristics.

Thus, depending on the program voltage, the reconfigurable electronic device of the present disclosure has been confirmed to have four distinct device characteristics (i.e., conductor, n-type semiconductor, insulator, and p-type semiconductor).

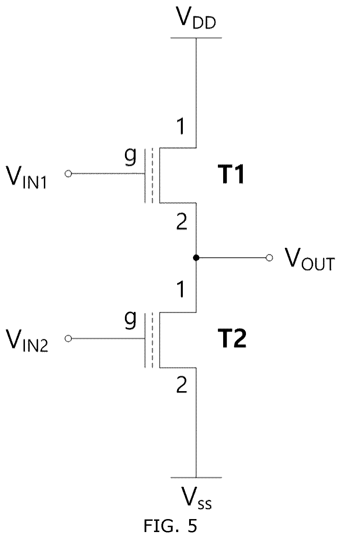

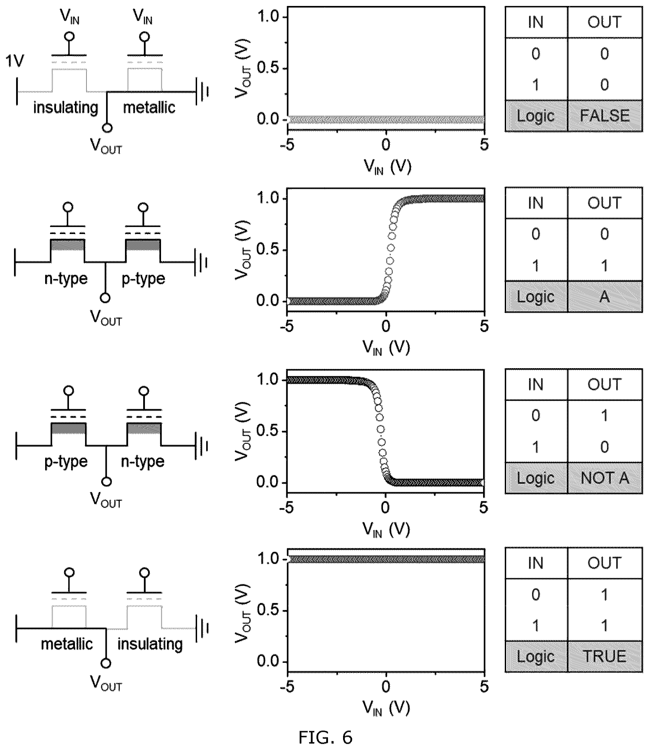

Referring to FIG. 5 and FIG. 6, a logic device according to an embodiment of the present disclosure will be described in detail. FIG. 5 is a circuit diagram of the logic device according to an embodiment of the present disclosure. FIG. 6 is a diagram explaining the operation of the logic device shown in FIG. 5.

The logic device shown in FIG. 5 includes two reconfigurable electronic devices T1, T2, a first power source V_{DD}, and a second power source V_{SS}. Here, the two reconfigurable electronic devices are referred to as the first electronic device T1 and the second electronic device T2, with each electronic device having the same structure as shown in FIGs. 1 to 2.

The first electronic device T1 and the second electronic device T2 are connected in series between the first power source V_{DD} and the second power source V_{SS}. Here, the first power source V_{DD} may be a power supply voltage, and the second power source V_{SS} may be a power ground voltage. A first electrode 1 of the first electronic device T1 is connected to the first power source V_{DD}. A second electrode 2 of the first electronic device T1 is connected to the first electrode 1 of the second electronic device T2, and an output signal V_{OUT} is output from their connection point. The second electrode 2 of the second electronic device T2 is connected to the second power source V_{SS}. A same input signal (A) is input into a control gate (g) of the first electronic device T1 and into a control gate (g) of the second electronic device T2.

Depending on the polarity and magnitude of the program voltage V_{IN1} applied to the control gate (g) of the first electronic device T1 and depending on the polarity and magnitude of the program voltage V_{IN2} applied to the control gate (g) of the second electronic device T2, the logic device of this embodiment may perform four logical operations. Here, the four logical operations are A, NOT A, TRUE, and FALSE for the input signal (A). Conventional CMOS inverters always function as logic gates of NOT A if n-type transistors and p-type transistors have structures connected in series, but the logic device of this embodiment may perform four logical operations using two reconfigurable electronic devices having the same structure.

The first logic device in FIG. 6 is a case where a program voltage ranging from the second voltage to the third voltage or the fourth voltage to the fifth voltage is applied to the first electronic device (insulating), setting the first electronic device (insulating) to have insulator characteristics, and a program voltage of less than or equal to the first voltage or greater than or equal to the sixth voltage is applied to the second electronic device (metallic), setting the second electronic device (metallic) to have conductor characteristics. This logic device performs a FALSE logical operation for the input signal (A).

The second logic device in FIG. 6 is a case where a program voltage ranging from the first voltage to the second voltage is applied to the first electronic device (n-type), setting the first electronic device (n-type) to have n-type semiconductor characteristics, and a program voltage ranging from the fifth voltage to the sixth voltage is applied to the second electronic device (p-type), setting the second electronic device (p-type) to have p-type semiconductor characteristics. This logic device performs an A logical operation for the input signal (A).

The third logic device in FIG. 6 is a case where a program voltage ranging from the fifth voltage to the sixth voltage is applied to the first electronic device (p-type), setting the first electronic device (p-type) to have p-type semiconductor characteristics, and a program voltage ranging from the first voltage to the second voltage is applied to the second electronic device (n-type), setting the second electronic device (n-type) to have n-type semiconductor characteristics. This logic device performs a NOT A logical operation for the input signal (A).

The fourth logic device in FIG. 6 is a case where a program voltage of less than or equal to the first voltage or greater than or equal to the sixth voltage is applied to the first electronic device (metallic), setting the first electronic device (metallic) to have conductor characteristics, and a program voltage ranging from the second voltage to the third voltage or the fourth voltage to the fifth voltage is applied to the second electronic device (insulating), setting the second electronic device (insulating) to have insulator characteristics. This logic device performs a TRUE logical operation for the input signal (A).

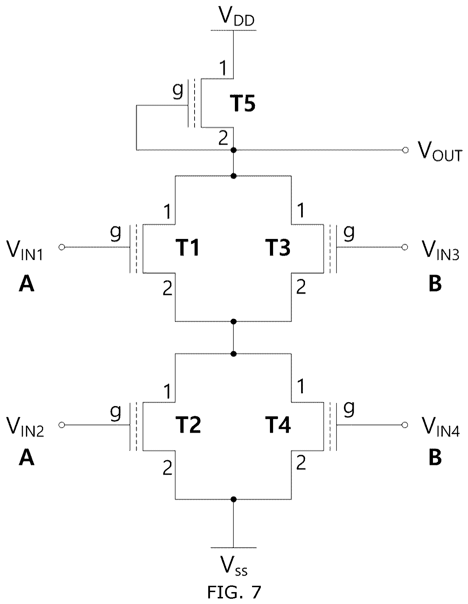

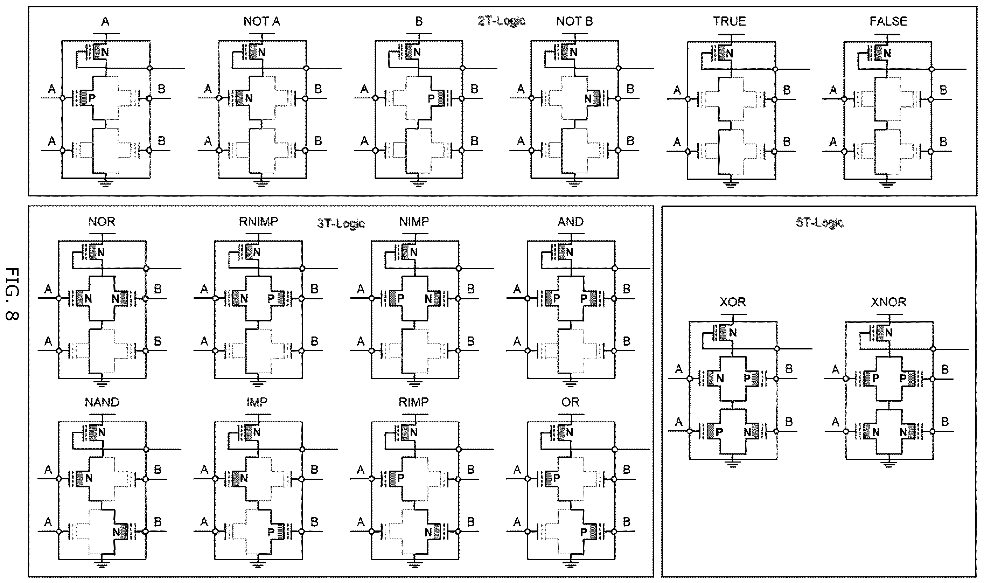

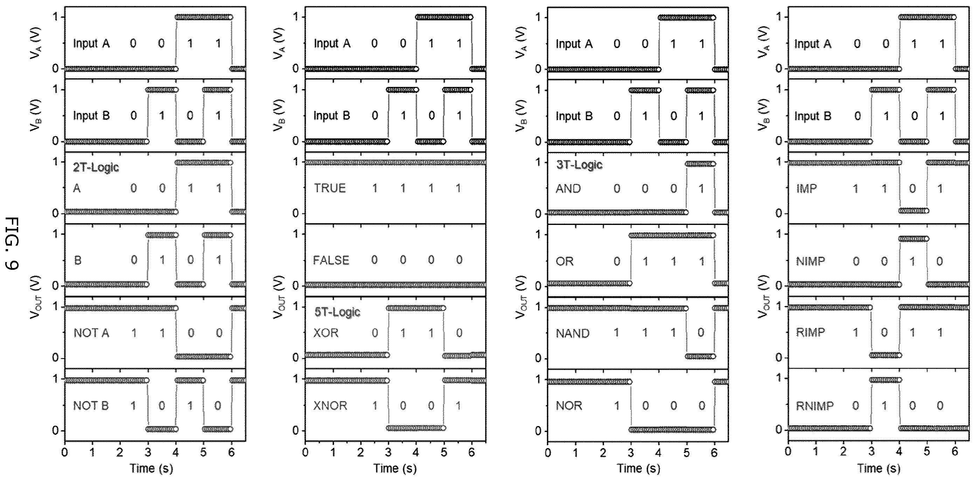

Hereinbelow, referring to FIGs. 7 to 9, a logic device according to another embodiment of the present disclosure will be described in detail. FIG. 7 is a circuit diagram of a logic device according to another embodiment of the present disclosure. FIG. 8 is a diagram illustrating the logic operations performed by the logic device of FIG. 7. FIG. 9 is a diagram illustrating the input signal and the output signal based on the logic operations of FIG. 8.

The logic device shown in FIG. 7 includes five reconfigurable electronic devices T1 to T5, a first power source V_{DD}, and a second power source V_{SS}. Here, the five reconfigurable electronic devices are referred to as a first electronic device T1, a second electronic device T2, a third electronic device T3, a fourth electronic device T4, and a fifth electronic device T5, and each electronic device has the same structure as shown in FIGs. 1 to 2.

A first electrode 1 of the fifth electronic device T5 is connected to the first power source V_{DD}, and the control gate (g) of the fifth electronic device T5 is connected to a second electrode of the fifth electronic device T5. The first electronic device T1 and the second electronic device T2 are connected in series between the second electrode 2 of the fifth electronic device T5 and the second power source V_{SS}. Here, the first power source V_{DD} may be a power supply voltage, and the second power source V_{SS} may be a power ground voltage. The third electronic device T3 and the fourth electronic device T4 are connected in series between the second electrode 2 of the fifth electronic device T5 and the second power source V_{SS}. The first electrode 1 of the first electronic device T1 and the first electrode 1 of the third electronic device T3 are connected to the second electrode 2 of the fifth electronic device T5, and an output signal V_{OUT} is output from their connection point. The second electrode 2 of the first electronic device T1, the first electrode 1 of the second electronic device T2, the second electrode 2 of the third electronic device T3, and the first electrode 1 of the fourth electronic device T4 are interconnected. The second electrode 2 of the second electronic device T2 and the second electrode 2 of the fourth electronic device T4 are connected to the second power source V_{SS}. The same first input signal (A) is input into the control gate (g) of the first electronic device T1 and into the control gate (g) of the second electronic device T2. The same second input signal (B) is input into the control gate (g) of the third electronic device T3 and into the control gate (g) of the fourth electronic device T4.

The channel layer of the fifth electronic device T5 is preset by a predetermined program voltage to have n-type semiconductor characteristics for all logical operations of the logic device. For example, the fifth electronic device T5 may be preset to have n-type semiconductor characteristics by applying a program voltage ranging from the first voltage to the second voltage, to the fifth electronic device T5.

Depending on the polarity and magnitude of the program voltage V_{IN1} applied to the control gate (g) of the first electronic device T1, depending on the polarity and magnitude of the program voltage V_{IN2} applied to the control gate (g) of the second electronic device T2, depending on the polarity and magnitude of the program voltage V_{IN3} applied to the control gate (g) of the third electronic device T3, and depending on the polarity and magnitude of the program voltage V_{IN4} applied to the control gate (g) of the fourth electronic device T4, the logic device of this embodiment may perform sixteen logical operations. Here, the sixteen logical operations are A, NOT A, B, NOT B, TRUE, FALSE, AND, OR, NOR, NAND, XOR, XNOR, IMP, NIMP, RIMP, and RNIMP for the first input signal (A) and the second input signal (B). The logic device according to this embodiment may perform sixteen logic operations using five reconfigurable electronic devices having the same structure.

Referring to FIG. 8 and FIG. 9, for example, a program voltage that is less than or equal to the first voltage or greater than or equal to the sixth voltage may be applied to any one of the first to fourth electronic devices to set that electronic device to have conductor characteristics. Alternatively, a program voltage ranging from the first voltage to the second voltage may be applied to any one of the first to fourth electronic devices to set that electronic device to have n-type semiconductor characteristics. Alternatively, a program voltage ranging from the second voltage to the third voltage or from the fourth voltage to the fifth voltage may be applied to any one of the first to fourth electronic devices to set that electronic device to have insulator characteristics. Alternatively, a program voltage ranging from the fifth voltage to the sixth voltage may be applied to any one of the first to fourth electronic devices to set that electronic device to have p-type semiconductor characteristics. Therefore, depending on the polarity and magnitude of the program voltage applied to the control gate of each electronic device, the logic device may perform sixteen logical operations.

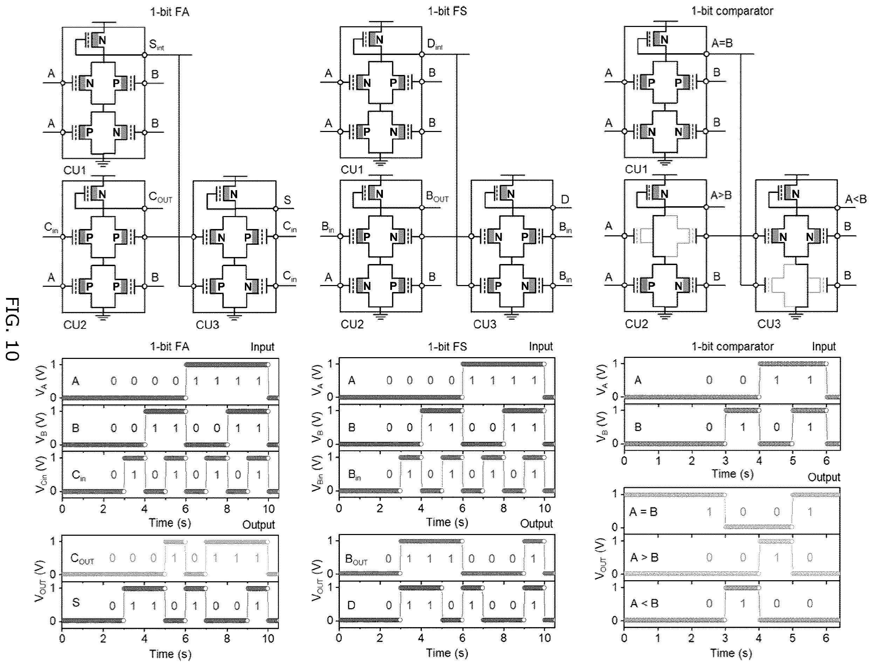

Hereinbelow, referring to FIG. 10, a logic device block according to one embodiment of the present disclosure will be described in detail. FIG. 10 a circuit diagram and logic operation diagram of a logic device block according to one embodiment of the present disclosure.

The logic device block illustrated in FIG. 10 is configured by connecting three logic devices of FIG. 7, each allowing to perform arithmetic operations such as addition (1-bit FA), subtraction (1-bit FS), and comparison (1-bit comparator).

While the embodiments of the present disclosure have been described above with reference to the accompanying drawings, those skilled in the art to which the present disclosure pertains will appreciate that the present disclosure may be implemented in other specific forms without changing its technical spirit or essential characteristics. Therefore, the embodiments described above should be understood as illustrative in all respects and not restrictive.

## Claims

1. A reconfigurable electronic device with transistor and memory functions using an ambipolar two-dimensional semiconductor, comprising:
a control gate;
a floating gate that is formed on the control gate and that is electrically insulated from surroundings;
a tunneling layer that is formed on the floating gate;
a channel layer that is formed on the tunneling layer and that is composed of the ambipolar two-dimensional semiconductor; and
a first electrode and a second electrode, that are formed on the channel layer to be spaced apart from each other,
wherein the channel layer has any one of the characteristics of a conductor, an n-type semiconductor, an insulator, and a p-type semiconductor depending on the polarity and magnitude of a program voltage applied to the control gate.

2. The reconfigurable electronic device according to claim 1,
wherein the channel layer is composed of least one ambipolar two-dimensional semiconductor selected from a group consisting of WSe₂, MoTe₂, and BP.

3. The reconfigurable electronic device according to claim 1,
wherein the floating gate is composed of at least one two-dimensional conductor selected from a group consisting of graphene and PtTe₂.

4. The reconfigurable electronic device according to claim 1,
wherein the tunneling layer is composed of at least one two-dimensional insulator selected from a group consisting of hBN and Sb₂O₃.

5. The reconfigurable electronic device according to claim 1,
wherein the floating gate, the tunneling layer, and the channel layer are all composed of two-dimensional materials, and are sequentially stacked on the control gate using a dry transfer method using a PDMS stamp.

6. The reconfigurable electronic device according to claim 1,
wherein as an absolute value of the program voltage increases with positive polarity, the channel layer sequentially has characteristics of the insulator, p-type semiconductor, and conductor.

7. The reconfigurable electronic device according to claim 1,
wherein as an absolute value of the program voltage increases with negative polarity, the channel layer sequentially has characteristics of the insulator, n-type semiconductor, and conductor.

8. The reconfigurable electronic device according to claim 1,
wherein when a first voltage < a second voltage < a third voltage < 0 < a fourth voltage < a fifth voltage < a sixth voltage,
if the program voltage is less than or equal to the first voltage or greater than or equal to the sixth voltage, the channel layer has conductor characteristics,
if the program voltage is ranging from the first voltage to the second voltage, the channel layer has n-type semiconductor characteristics,
if the program voltage is ranging from the second voltage to the third voltage or from the fourth voltage to the fifth voltage, the channel layer has insulator characteristics, and
if the program voltage is ranging from the fifth voltage to the sixth voltage, the channel layer has p-type semiconductor characteristics.

9. A method of manufacturing a reconfigurable electronic device with transistor and memory functions using an ambipolar two-dimensional semiconductor, comprising:
preparing a control gate;
sequentially stacking a floating gate, a tunneling layer, and a channel layer on the control gate using a dry transfer method using a PDMS stamp, the channel layer being composed of the ambipolar two-dimensional semiconductor;
forming a resist pattern on the channel layer; and
forming a first electrode and a second electrode, that are spaced apart from each other, on the channel layer that is exposed by the resist pattern,
wherein the channel layer has any one of the characteristics of a conductor, an n-type semiconductor, an insulator, and a p-type semiconductor depending on the polarity and magnitude of a program voltage applied to the control gate.

10. A logic device comprising:
a first electronic device according to claim 1, a second electronic device according to claim 1, a first power source, and a second power source,
wherein the first electronic device and the second electronic device are connected in series between the first power source and the second power source,
a first electrode of the first electronic device is connected to the first power source,
a second electrode of the first electronic device is connected to a first electrode of the second electronic device, and from a connection point thereof, an output signal is output,
a second electrode of the second electronic device is connected to the second power source, and
a same input signal (A) is input into a control gate of the first electronic device and into a control gate of the second electronic device.

11. The logic device according to claim 10,
wherein the logic device performs four logical operations depending on the polarity and magnitude of a program voltage applied to the control gate of each electronic device.

12. The logic device according to claim 11,
wherein the four logical operations are A, NOT A, TRUE, and FALSE for the input signal (A).

13. A logic device comprising:
a first electronic device according to claim 1, a second electronic device according to claim 1, a third electronic device according to claim 1, a fourth electronic device according to claim 1, a fifth electronic device according to claim 1, a first power source and a second power source,
wherein a first electrode of the fifth electronic device is connected to the first power source, a control gate of the fifth electronic device is connected to a second electrode of the fifth electronic device,
the first electronic device and the second electronic device are connected in series between a second electrode of the fifth electronic device and the second power source,
the third electronic device and the fourth electronic device are connected in series between the second electrode of the fifth electronic device and the second power source,
a first electrode of the first electronic device and a first electrode of the third electronic device are connected to the second electrode of the fifth electronic device, and from a connection point thereof, and an output signal is output,
a second electrode of the first electronic device, a first electrode of the second electronic device, a second electrode of the third electronic device, and a first electrode of the fourth electronic device are interconnected,
a second electrode of the second electronic device and a second electrode of the fourth electronic device are connected to the second power source,
a same first input signal (A) is input into a control gate of the first electronic device and into a control gate of the second electronic device, and
a same second input signal (B) is input into a control gate of the third electronic device and into a control gate of the fourth electronic device.

14. The logic device according to claim 13,
wherein the logic device performs sixteen logical operations depending on the polarity and magnitude of a program voltage applied to the control gate of each electronic device.

15. The logic device according to claim 14,
wherein the sixteen logical operations are A, NOT A, B, NOT B, TRUE, FALSE, AND, OR, NOR, NAND, XOR, XNOR, IMP, NIMP, RIMP and RNIMP for the first input signal (A) and the second input signal (B).

16. The logic device according to claim 13,
wherein a channel layer of the fifth electronic device is set to have n-type semiconductor characteristics by a program voltage.
